# EUROPÄISCHE PATENTSCHRIFT

(11) **EP 0 545 269 B1**
(45) Veröffentlichungstag und Bekanntmachung des Hinweises auf die Patenterteilung: **01.02.1995**
(21) Anmeldenummer: 92120138.0
(22) Anmeldetag: 26.11.1992
(51) Int. Cl.: H01S 3/085, H01S 3/106, G02F 3/02, H04B 10/04, H04J 14/00

(54) **Verfahren zum Betreiben eines Halbleiterlasers als bistabiles optoelektronisches Bauelement**
Method of operating a semi-conductor laser as an optoelectronic bistable element
Méthode pour commander un laser à semi-conducteur comme élément optoélectronique bistable

(30) Priorität: 02.12.1991 DE 4139663
(43) Veröffentlichungstag der Anmeldung: 09.06.1993
(73) Patentinhaber: Alcatel SEL Aktiengesellschaft, D-70435 Stuttgart (DE); ALCATEL N.V., NL-1077 XX Amsterdam (NL)
(72) Erfinder: Baums, Dieter, Dr., W-7140 Ludwigsburg (DE); Laube, Gert, Dr., W-7000 Stuttgart 40 (DE); Schilling, Michael, W-7000 Stuttgart 31 (DE); Wünstel, Klaus, Dr., W-7141 Schwieberdingen (DE); Idler, Wilfried, W-7145 Markgröningen (DE); Hildebrand, Olaf, Dr., W-7000 Stuttgart 61 (DE)
(74) Vertreter: Kugler, Hermann, Dipl.-Phys.

(56) Entgegenhaltungen:
- EP-A- 0 418 705
- 17TH EUROPEAN CONFERENCE ON OPTICAL COMMUNICATION ECOC 91, INVITED PAPERS, BD.2, 9/12 SEPTEMBER, 1991, PARIS, FRANKREICH,Seiten 39 - 46,O. HILDEBRAND et al.'The integrated interferometric injection laser (Y-laser): one device concept for various system applications'
- IEEE PHOTONICS TECHNOLOGY LETTERS Bd. 2, Nr. 2, Februar 1990, NEW YORK,US, Seiten 109-110;HAJIME SHOJI et al.:'Fast bistable wavelength switching characteristics in two-electrode distributed feedback laser'
- IEEE JOURNAL OF QUANTUM ELECTRONICS. Bd. 27, Nr. 6, Juni 1991, NEW YORK US, Seiten 1616-1624,MICHAEL SCHILLING et al. 'Integrated interferometric injection laser: novel fast and broad-band tunable monolithic light source'
- 16TH EUROPEAN CONFERENCE ON OPTICAL COMMUNICATION ECOC 90, REGULAR PAPERS, BD.1, 16/20 SEPTEMBER, 1990, AMSTERDAM, NL,Seiten 479 - 481;W. IDLER et al. 'Highspeed integrated interferometric injection laser with 22 nm tuning range'
- ELECTRONICS LETTERS. Bd. 19, Nr. 22, 27. Oktober 1983, ENAGE GB,Seiten 926 -927;I.D. HENNING et al. 'Electrical tuning of semiconductor interferometric laser'

## Beschreibung

Die Erfindung geht aus von einem Halbleiterlaser mit verzweigter Kavität.

Ein solcher Halbleiterlaser ist bekannt aus Electronics Letters, 15th Feburary, 1990, Vol. 26, No. 4, Seiten 243 bis 244. Er ist auf einem n-dotierten Indiumphosphid-Substrat monolithisch integriert. Die untere Seite des Substrats wird als Grundfläche bezeichnet. Oberhalb einer zur Grundfläche koplanaren Ebene erstreckt sich eine Kavität aus Indium-Gallium-Arsenid-Phosphid (InGaAsP). Sie ist verzweigt und hat in der Draufsicht die Form eines "Y". Die Draufsicht-Fläche der Kavität kann auch eine andere Form, z.B. die Form eines Kreuzes, haben. Wesentlich ist, daß die Kavität zusammenhängend ist. Dies läßt sich im Sinne einer topologischen Definition so beschreiben, daß die Draufsicht-Fläche der Kavität als "einfach zusammenhängendes Gebiet" aufzufassen ist, da sie nicht aus mehreren Stücken, sondern aus einem einzigen Stück mit einem einzigen Rand besteht. Die Kavität liegt auf der ebenen Oberfläche einer n-dotierten Pufferschicht aus Indiumphosphid, die sich oberhalb des Indiumphosphid-Substrats erstreckt.

Oberhalb der Kavität sind weitere Schichten vorhanden. Diese und die Kavität bilden oberhalb der Pufferschicht eine Mesa, die durch Ätzen entstanden ist. Die Mesa hat in der zur Grundfläche koplanaren Ebene ebenso wie die Kavität eine Y-Form.

Ein solcher Laser mit verzweigter Kavität ist gemäß der oben genannten Veröffentlichung vorgesehen als elektrisch steuerbare Lichtquelle für optische Nachrichtenübertragungssysteme. Insbesondere, wenn seine oberhalb der Kavität verlaufende Metallschicht in mehrere Elektroden unterteilt ist, so daß es dadurch Bereiche der Kavität gibt, die durch unterschiedliche Betriebsströme steuerbar sind, zeichnet sich der Laser durch eine über einen sehr weiten Wellenlängenbereich reichende Abstimmbarkeit seiner Emissionswellenlänge aus. Diese Eigenschaft steht bei der in der Veröffentlichung vorgesehenen Anwendung als elektrisch steuerbare Lichtquelle im Vordergrund.

Auch aus 17th European Conference on Optical Communication ECOC′91, invited papers, Bd. 2, 9/12.Sept. 1991, Paris, Frankreich, Seiten 39-46 ist ein Halbleiterlaser mit den eingangs genannten Eigenschaften bekannt. Anhand von Figur 8 jener Veröffentlichung ist eine Betriebsweise erläutert, bei der die Ausgangswellenlänge umschaltbar ist. Die Ausgangswellenlänge wechselt von einem voreingestellten ersten Wert auf einen zweiten Wert, der gleich der Wellenlänge von in einen optischen Eingang eingestrahltem Licht ist, wenn die Leistung dieses eingestrahlten Lichts eine bestimmte Schwelle überschreitet. Die Ausgangswellenlänge ist also dabei in eindeutiger Weise abhängig von der Leistung des eingestrahlten Lichts.

Für die optische Übertragung gewinnen bistabile Bauelemente eine immer größere Bedeutung. "Bistabil" bedeutet, daß das Bauelement bei gleicher Ansteuerung, d.h. bei gleichem Strom oder gleicher Spannung, in zwei verschiedenen Zuständen sein kann, d.h. Licht niedriger oder großer Intensität oder Licht einer ersten oder Licht einer zweiten Wellenlänge emittiert, je nachdem, auf welche Weise ein betrachteter Ansteuerungs-Zustand erreicht worden ist.

Bistabile Bauelemente eignen sich zur Anwendung als optische Schalter oder Speicher in Wellenlängen-Multiplex-Vermittlungssystemen und in Systemen für die optische Datenverarbeitung.

Aus IEEE Photon. Techn. f. Lett., 2 (1990), Seiten 623 bis 625 ist ein DFB-Halbleiterlaser bekannt, der aus zwei Segmenten besteht und der als wellenlängen-bistabiler Speicher betrieben wird. Innerhalb von 450 Picosekunden läßt er sich durch elektrische Impulse setzen und zurücksetzen. Der DFB-Halbleiterlaser strahlt jeweils Licht mit einer von zwei Wellenlängen aus, die einen Abstand von 0,9 nm haben.

Es ist die Aufgabe der Erfindung, ein Verfahren zu schaffen, durch das Halbleiterlaser mit einer verzweigten Kavität als optische Schalter und Speicher eingesetzt werden können.

Die Aufgabe wird wie im Patentanspruch 1 angegeben gelöst.

Weiterbildungen ergeben sich aus den Unteransprüchen.

In der neuen Betriebsart als wellenlängen-bistabiles Bauelement läßt sich der Halbleiterlaser z.B. als Teil eines Multiplexers oder Demultiplexers oder als optisches Abtast- und Halteglied verwenden.

Nachstehend wird die Erfindung in Ausführungsbeispielen anhand der Zeichnungen näher erläutert. Es zeigen:
- Fig. 1: einen an sich bekannten Halbleiterlaser mit einer verzweigten Kavität
- Fig. 2: die Wellenlänge des von dem Halbleiterlaser emittierten Lichtsignals als Funktion des durch einen seiner Bereiche fließenden Stromes und
- Fig. 3: ein Taktdiagramm zur Erläuterung einer Anwendung, bei der der Halbleiterlaser elektrisch und optisch gesteuert wird.

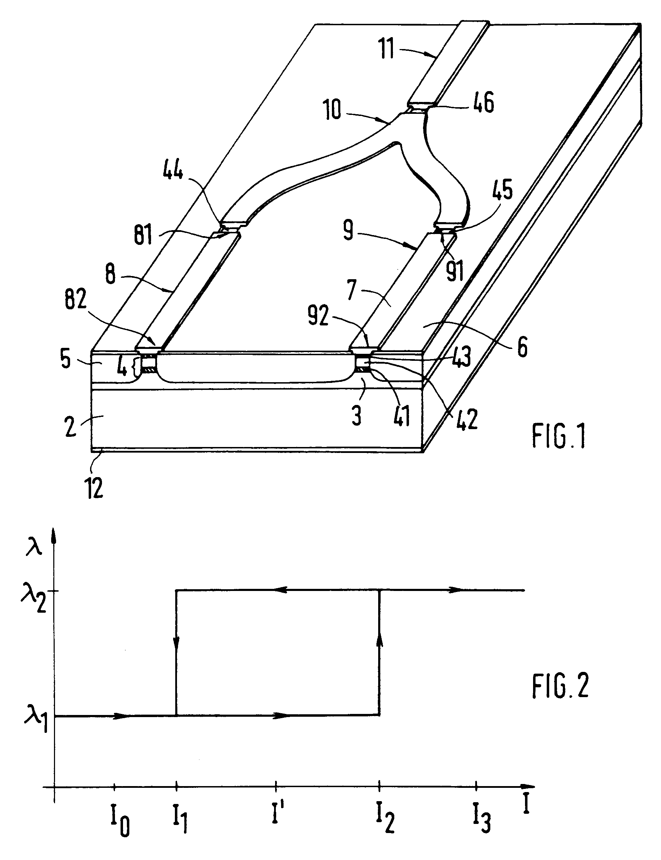

In Fig. 1 ist der bekannte Halbleiterlaser mit verzweigter Kavität dargestellt.

Er hat ein Substrat 2 aus n-dotiertem Indiumphosphid. Darüber liegt eine Pufferschicht 3, die ebenfalls aus n-dotiertem Indiumphosphid besteht und von der ein Teil die unterste Schicht einer Mesa 4 bildet, die in der Draufsicht die Form eines Y hat. Die Mesa 4 hat mehrere Schichten. Sie enthält eine Kavität 41 aus Indium-Gallium-Arsenid-Phosphid. Diese wird von einer Mantelschicht 42 aus p-dotiertem Indiumphosphid bedeckt. Darüber liegt eine Kontaktschicht 43 aus p⁺-dotiertem Indium-Gallium-Arsenid. Seitlich der Mesa 4 und oberhalb der nicht durch die Schicht 41 bedeckten Oberfläche der Pufferschicht 3 ist zur elektrischen Isolation und zur optischen Wellenführung in der Mesa 4 eine Schicht aus semiisolierendem Indiumphosphid vorhanden, deren obere Oberfläche mit der oberen Oberfläche der Kontaktschicht 43 eine Ebene bildet. Die Schicht 5 ist mit einer Schutzschicht 6 aus Siliziumdioxid bedeckt, die Kontaktschicht 43 mit einer Metallschicht 7.

In die Metallschicht 7 und die Mesa 4 sind drei Gräben 44, 45, 46 hineingeätzt, durch die der Laser in vier Bereiche 8, 9, 10 und 11 eingeteilt ist. Gemäß der Darstellung in Fig. 1 können die Gräben 44, 45, 46 entsprechend der optischen Kopplung, die die Bereiche 8 bis 11 untereinander haben sollen, auch bis in die Mantelschicht 42, jedoch nicht bis in die Kavität 41 hinabreichen. Die Metallschicht 7 bildet in jedem Bereich 8 bis 11 eine erste Elektrode. Eine zweite Elektrode wird für jeden Bereich 8 bis 11 durch eine Metallschicht 12 gebildet, die unterhalb des Substrats 2 aufgebracht ist. Von der Metallschicht 7 jedes der Bereiche 8 bis 11 fließt beim Betrieb des Halbleiterlasers 1 durch den jeweiligen Bereich 8 bis 11 ein jeweils einzeln fest einstellbarer oder veränderbarer Strom zu der Metallschicht 12, die als Massekontakt dient. Diese Stromrichtung ist als Durchlaßrichtung des jeweiligen Bereichs des Lasers zu betrachten.

Die Kavität 41 kann in ihrem Querschnitt eine Quantum-Well-Schichtstruktur haben, wie sie z.B. aus Appl. Phys. Lett. 39 (1981), S. 786 bis 788 bekannt ist. Sie kann aber auch eine andere Schichtstruktur haben. Für die Erfindung spielt dies keine Rolle.

Der Halbleiterlaser 1 emittiert, wenn seine Kavität 41 die Zusammensetzung In_{0,62}Ga_{0,38}As_{0,82}P_{0,18} hat, Licht im Wellenlängenbereich um 1520 nm.

Hat die Kavität 41 eine Zusammensetzung In_{0,57}Ga_{0,43}As_{0,73}P_{0,27}, so emittiert er Licht im Wellenlängenbereich um 1300 nm. In beiden Fällen ist der Wellenlängenbereich durch Verändern der Betriebsströme um mindestens ±20 nm durchstimmbar.

Der Halbleiterlaser 1 kann auch als GaA1As/GaAs-Halbleiterlaser aufgebaut sein; ein derartiger Aufbau ist z.B. aus Appl. Phys. Lett., 52(1988), S. 767 bis 769 bekannt.

Die Mesa 4 und damit die Kavität 41 läßt sich nicht nur, wie in Fig. 1 dargestellt, in Form eines "Y" aufbauen, sondern beispielsweise auch in Kreuzform, wie sie dieser Veröffentlichung ebenfalls zu entnehmen ist.

Für jeden der Bereiche 8 - 11 lassen sich insoweit ein Transparenzstrom und ein Laser-Schwellenstrom definieren, als man jeden Bereich als einzelnen Fabry-Pèrot-Laser auffassen kann, der sich unabhängig von den anderen Bereichen betreiben ließe. Unter dem Transparenzstrom wird derjenige Strom verstanden, der erforderlich ist, um den Bereich für Licht der Wellenlänge durchlässig zu machen, die er selber emittieren würde, wenn er im laseraktiven Zustand wäre. Unter dem Laser-Schwellenstrom wird derjenige durch den betrachteten Bereich fließende Strom verstanden, bei dem der Bereich als Laser aktiv wird und kohärentes Licht aussendet.

Unter "Licht" wird hier und im folgenden jegliche optische Strahlung verstanden, auch wenn ihre Wellenlänge außerhalb des sichtbaren Bereichs liegt.

Nachstehend wird ein erstes Beispiel des neuen Verfahrens zum Betreiben des in Fig. 1 gezeigten Halbleiterlasers beschrieben.

Der Bereich 11 des Halbleiterlasers wird oberhalb seines Laser-Schwellenstroms betrieben, d.h. beispielsweise von einem Strom von 60 mA durchflossen.

Die Ströme, die durch die Bereiche 8 und 9 fließen, haben eine Stromstärke zwischen z.B. 10 und 40 mA, die Bereiche sind also transparent. Für Schaltzwecke reicht es auch aus, daß zu bestimmten Zeitpunkten nur einer der Bereiche 8 und 9 transparent ist.

Durch den Bereich 10 fließt beispielsweise ein Strom, der zwischen einem Strom I₁=4mA und einem Strom I₅=25mA liegt.

In Fig. 2 ist dargestellt, wie die Emissionswellenlänge des Halbleiterlasers nach Fig. 1 in Abhängigkeit von einem Strom I, der bei der vorstehend beschriebenen Betriebsweise des Halbleiterlasers durch den Bereich 10 fließt, variiert. Variiert man die Stromstärke beginnend mit einer Stromstärke von I₀, die unterhalb von I₁ liegt, indem man sie ansteigen läßt, so ändert sich bei einer Stromstärke I₂, die zwischen 20 und 25 mA liegt, wie in Fig. 2 dargestellt, die Wellenlänge λ₁ des vom Halbleiterlaser 1 emittierten Lichts sprunghaft in die Wellenlänge λ₂. I₂ wird im folgenden "obere Stromschwelle" genannt. Verringert man nun in umgekehrter Richtung, z.B. von einer oberhalb von I₂ liegenden Stromstärke I₃ beginnend, die Stromstärke, so bleibt die Wellenlänge λ gleich der Wellenlänge λ₂, auch unterhalb von I₂ und ändert sich erst dann in die Wellenlänge λ₁, wenn eine untere Stromschwelle I₁, die beispielsweise bei 4 mA liegt, unterschritten wird.

Zwischen der unteren Stromschwelle I₁ und der oberen Stromschwelle I₂ kann also die Emissionswellenlänge des Halbleiterlasers zwei verschiedene Werte haben, abhängig davon, von welchem Ausgangswert und mit welchem Hub die Stromstärke des durch den Bereich 10 fließenden Stromes geändert wird. Die Kurve der Fig. 2 zeigt also das für bistabile Bauelemente typische Hysterese-Verhalten eines Zustandes abhängig von einer Steuergröße, wobei hier der Zustand die Emissionswellenlänge und die Steuergröße der durch den Bereich 10 fließende Strom I ist.

Wenn also ein elektrisches Signal an den Bereich 10 angelegt wird, dessen Stromstärke mindestens 4 mA beträgt, auf einen Wert von 25 mA oder mehr ansteigt und wieder auf den Wert 4 mA abfällt, so erzeugt der Halbleiterlaser abwechselnd Licht der Wellenlänge λ₁ oder λ₂.

Die Wellenlänge λ₁ beträgt beispielsweise 1559 nm, die Wellenlänge λ₂ 1565 nm, d.h. es läßt sich eine Wellenlängendifferenz von mehreren Nanometern erzielen.

Physikalisch beruht die bei der vorstehend geschilderten Betriebsweise erzielbare Wellenlängenänderung auf einer Änderung des effektiven Brechungsindex für die im Verzweigungsbereich der Kavität sich ausbreitenden Lasermoden. Die Wellenlängen-Bistabilität beruht also auf einem dispersiven Effekt, der von der Stromänderung verursacht wird.

Alternativ zu der vorstehend geschilderten Betriebsweise kann man den Halbleiterlaser auch wie folgt betreiben:

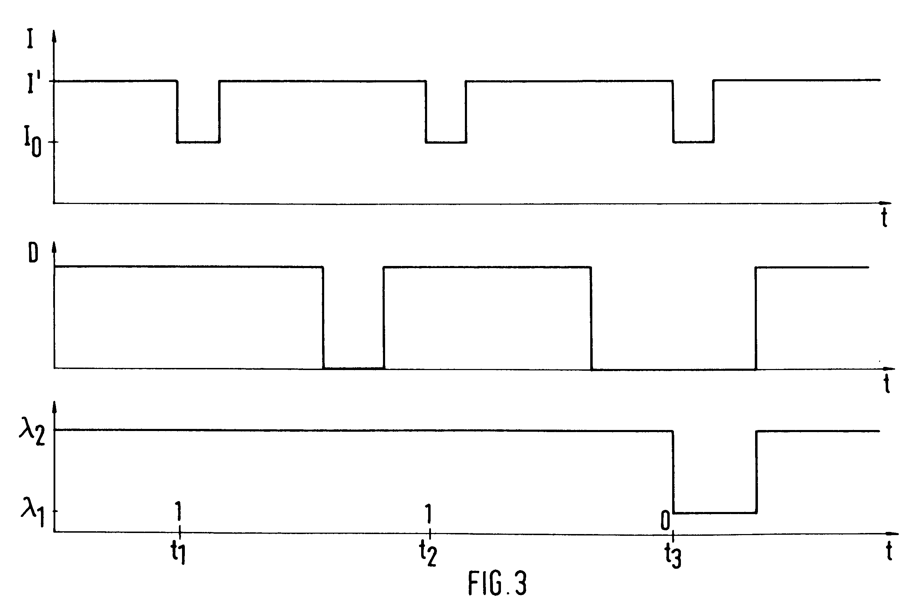

Durch den Bereich 11 läßt man einen solchen Betriebsstrom fließen, der oberhalb des Laser-Schwellenstroms liegt, so daß der Bereich 11 laseraktiv ist. Durch einen der Bereiche 8, 9 und 10 läßt man einen solchen Betriebsstrom fließen, der bewirkt, daß der betreffende Bereich für im Bereich 11 erzeugtes Licht als sättigbarer Absorber wirkt, wogegen man die anderen beiden Bereiche von den Bereichen 8, 9 und 10 mit einem solchen Betriebsstrom versorgt, der sie für das im Bereich 11 erzeugte Licht transparent macht. Als sättigbarer Absorber wirkt ein Bereich dann, wenn an ihm eine entgegen der Durchlaßrichtung gerichtete Spannung anliegt oder wenigstens kein Strom in Durchlaßrichtung durch ihn fließt. Beispielsweise wird der Bereich 10 durch eine feste Vorspannung als sättigbarer Absorber betrieben, wogegen gleichzeitig die Bereiche 8 und 9 durch geeignete feste Ströme so betrieben werden, daß sie sich im Transparenz-Zustand befinden. Variiert man nun den durch den Bereich 11 fließenden Strom, so wird dadurch der Absorptionszustand des sättigbaren Absorbers 10 und damit die effektive Resonatorlänge geändert, wodurch schließlich die Wellenlänge des ausgesandten Lichts geändert wird. Auch diese Änderung der Wellenlänge des ausgesandten Lichts hat ein Hysterese-Verhalten, so daß eine wellenlängen-bistabile Betriebsweise entsprechend dem in Fig. 3 gezeigten Wellenlängen-Verhalten entsteht. Diese Art von Wellenlängen-Bistabilität bezeichnet man als absorptive Bistabilität.

Bei dieser Betriebsweise ändert sich aufgrund des geänderten Absorptionszustands des sättigbaren Absorbers gleichzeitig mit der Wellenlänge auch die Intensität des emittierten Lichts. Die Intensitätsänderung verläuft dabei analog der in Fig. 2 gezeigten Wellenlängenänderung. Das Bauelement 10 läßt sich durch die neue Betriebsweise auch als intensitäts-bistabiles optoelektronisches Bauelement verwenden.

Gleichgültig ob die erzielte Bistabilität wie bei der ersten geschilderten Betriebsweise eine dispersive Bistabilität oder wie bei der zweiten geschilderten Betriebsweise eine absorbtive Bistabilität ist, haben beide Betriebsweisen folgendes gemeinsam: In einem der Bereiche des Halbleiterlasers (im ersten Falle im Bereich 10 und im zweiten Falle im Bereich 11) wird durch eine Stromänderung die Ladungsträgerdichte so geändert, daß der Halbleiterlaser Licht mit einer ersten oder zweiten Wellenlänge emittiert.

Es läßt sich eine Vielzahl von praktischen Anwendungsfällen vorstellen, in denen es nützlich ist, den Halbleiterlaser nach Fig. 1 gemäß dem erfindungsgemäßen Verfahren als bistabiles optoelektronisches Bauelement zu betreiben.

Beispielsweise kann der Halbleiterlaser nach dem erfindungsgemäßen Verfahren als Teil eines Demultiplexers eingesetzt werden. Wenn z.B. zwei elektrische Signale S′ und S˝ miteinander multiplexiert sind und jedes der beiden Signale S′ und S˝ zu Beginn eine Adressierung enthält, wie dies z.B. bei paketweise übertragenen Digitalsignalen der Fall ist, wobei jedem Datenpaket eine Adressierung vorangestellt ist, die bestimmt, wohin das Datenpaket vermittelt werden soll, so kann man zunächst die beiden Digitalsignale so umsetzen, daß ihr Strom innerhalb der Stromschwellen I₁ und I₂ schwankt, und man kann die den Digitalsignalen vorangestellte Adressierung durch einen kurzen Stromimpuls ersetzen, der im Falle der dem einen Signal vorangestellten Adressierung eine Stromstärke I₀ hat, d.h. durch einen Stromimpuls, der die untere Strom-Schwelle I₁ unterschreitet, und man kann die dem zweiten Digitalsignal vorangestellte Adressierung durch einen Stromimpuls der Stromstärke I₃ ersetzen, d.h. durch einen Stromimpuls, der die obere Stromschwelle I₂ überschreitet. Steuert man nun mit einem derart modifizierten elektrischen Multiplex-Signal gemäß der ersten oben geschilderten Betriebsart den Bereich 10 des Halbleiterlasers an, so emittiert er ein entsprechendes optisches Multiplex-Signal, wobei das darin enthaltene Signal S′ die Wellenlänge λ₁ und das darin enthaltene Signal S˝ die Wellenlänge λ₂ hat. Beide Signale können nun aufgrund ihrer verschiedenen Wellenlänge mit optischen Mitteln voneinander getrennt werden.

Ein Aspekt dieser Betriebsweise ist auch, daß man das Halbleiterbauelement als einen Elektrisch-Optisch-Wandler verwendet, wobei die Wellenlänge des entstehenden optischen Signals durch einen Steuerimpuls steuerbar ist, der dem elektrischen Signal, das den änderbaren Strom moduliert, vorangestellt ist.

Umgekehrt läßt sich der Halbleiterlaser nach dem erfindungsgemäßen Verfahren auch so einsetzen, daß er als Teil eines Multiplexers wirkt. Die zu multiplexierenden Signale werden dabei so modifiziert, daß ihre Stromstärke zwischen I₁ und I₂ schwankt und dem einen ein I₁ unterschreitender Steuerimpuls und dem anderen ein I₂ überschreitender Steuerimpuls vorangestellt wird. Steuert man nun mit dem einen Signal den Bereich 10 eines Halbleiterlasers nach Fig. 1 an und mit dem anderen Signal ebenfalls den Bereich 10 eines zweiten entsprechenden Halbleiterlasers, so wird das erste elektrische Signal in ein Lichtsignal mit der Wellenlänge λ₁ und das zweite elektrische Signal in ein Lichtsignal mit der Wellenlänge λ₂ umgesetzt. Beide Lichtsignale können dann im Wellenlängenmultiplex über einen Lichtwellenleiter übertragen werden.

Da man somit die Wahl hat, durch einen geeigneten Steuerimpuls zu steuern, ob das Lichtsignal die Wellenlänge λ₁ oder die Wellenlänge λ₂ haben soll, kann man damit auch steuern, ob ein optisches Vermittlungselement, das die Eigenschaft hat, Licht einer ersten Wellenlänge an einem anderen Ausgang auszugeben als Licht einer zweiten Wellenlänge, an einem bestimmten Ausgang das Signal S′ oder das Signal S˝ ausgeben soll.

Im folgenden wird noch ein drittes Ausführungsbeispiel des erfindungsgemäßen Verfahrens erläutert. Bei den vorstehend beschriebenen Ausführungsbeispielen wurden die für den Laserbetrieb notwendigen Ladungsträger allein durch Strominjektion in einen der Bereiche 8 bis 11 erzeugt. Stattdessen ist es auch möglich, die Ladungsträgeränderung in dem jeweiligen Bereich, die für die Wellenlängen-Bistabilität sorgt, auch ausschließlich durch Lichteinstrahlung in mindestens einen der Bereiche 8, 9 und 11 zu steuern, wobei das Licht eine höhere Energie als das von dem Halbleiterlaser emmitierte Licht hat. Es ist auch möglich, die Ladungsträgeränderung in einem der Bereiche zum Teil durch Strominjektion und zum Teil durch Lichteinstrahlung zu steuern. Beispielsweise läßt sich Licht der Wellenlänge 800, 1300 oder 1530 nm in einen Halbleiterlaser einstrahlen, der Licht mit einer Wellenlänge von 1560 nm emittiert. Das einzustrahlende Licht läßt sich wiederum durch einen Halbleiterlaser erzeugen.

Nachstehend wird auch für eine durch Strominjektion und durch gleichzeitige Lichteinstrahlung steuerbare Ladungsträgeränderung ein nützlicher Anwendungsfall beschrieben. Dabei läßt man beispielsweise durch den Bereich 10 einen Strom fließen, dessen Stärke zwischen der Stromstärke I₀ (s. Fig. 2) und der Stromstärke I′ wechselt, wobei I′ gerade größer als die untere Stromschwelle I, aber kleiner als die obere Stromschwelle I₂ ist. In Fig. 3 ist in der obersten Zeile ein solcher Stromverlauf gezeigt, der, wie noch erläutert wird, als Takt dient.

In einen der Bereiche 11, 8 oder 9, beispielsweise in den Bereich 11, wird als Datensignal D ein Lichtsignal mit einer Wellenlänge λ₀ eingestrahlt. Die Wellenlänge λ₀ ist kürzer als die Wellenlänge λ₁ und λ₂, so daß sie die Erzeugung von Ladungsträgern in dem Bereich 10 ermöglicht. Das Lichtsignal, das ein Datensignal D darstellt, ist intensitätsmoduliert, so daß es entsprechend dem Datensignal, das es darstellt, zwischen einer höheren Intensität und einer niedrigeren Intensität (z.B. Intensität 0) wechselt.

Die höhere Intensität des Lichtsignals wird so gewählt, daß die Zahl der im Bereich 10 durch sie erzeugten Ladungsträger geringer ist als die Zahl, die sich ergibt, wenn die Ladungsträger allein durch einen durch den Bereich 10 fließenden Strom erzeugt werden, wobei die Stromstärke des durch den Bereich 10 fließenden Stroms oberhalb I₂, z.B. bei I₃, liegt. Die höhere Intensität des Lichtsignals reicht also nicht aus, um den Halbleiterlaser in den Zustand zu bringen, in dem sein emittiertes Licht die Wellenlänge λ₂ hat. Wenn aber gleichzeitig mit einer solchen Lichteinstrahlung ein Strom mit einer Stromstärke I′ (Fig. 2), die zwischen I₁ und I₂ liegt und daher für sich alleine auch nicht ausreichen würde, um den Halbleiterlaser in den Zustand mit der Emissonswellenlänge λ₂ zu bringen, durch den Bereich 10 fließt, so gelangt durch die gemeinsame Wirkung von Licht und Strom der Halbleiterlaser in diesen Zustand.

Man läßt also bei der geschilderten Anwendung einen Strom I mit den in Fig. 3 gezeigten wechselnden Stromstärken I₀ und I′ als Takt durch den Bereich 10 fließen und strahlt ein Lichtsignal D in den Bereich 11 ein, während die übrigen Bedingungen wie folgt sind: Durch einen festen Vorstrom wird der Bereich 11 im laseraktiven Zustand betrieben, während die Bereiche 8 und 9 ebenfalls durch feste Betriebsströme im Transparenz-Zustand betrieben werden.

Unter diesen Bedingungen emittiert der Halbleiterlaser aus den Bereichen 8 und 9 Licht mit der Wellenlänge λ₂, solange nicht gleichzeitig das Lichtsignal die niedrige Intensität und das Taktsignal die Stromstärke I₀ hat. Bei dem in Fig. 3 gezeigten Beispiel ändert sich somit die Emissionswellenlänge zu dem auf der Zeitachse angegebenen Zeitpunkt t₃, da zu diesem Zeitpunkt nicht nur das Lichtsignal die niedrige Intensität hat, sondern auch der Strom I auf seinen unteren Wert I₀ zurückgeht. Die Emissionswellenlänge springt erst dann wieder auf die Wellenlänge λ₂, wenn sowohl das Lichtsignal wieder die höbere Intensität hat, als auch der Strom I die erhöhte Stromstärke I′ hat.

Gibt man dem Datensignal D in Fig. 3 den logischen Wert 1, wenn die Lichtintensität des es darstellenden optischen Signals den höheren Wert hat und den logischen Wert 0, wenn die Lichtintensität den niedrigeren Wert hat, und gibt man dem emittierten Lichtsignal den logischen Wert 1 wenn seine Wellenlänge gleich λ₂ ist und den logischen Wert 0, wenn seine Wellenlänge gleich λ₁ ist, so sieht man aus Fig. 3 das folgende: Zu Zeitpunkten t₁, t₂ und t₃, zu denen der Strom I, also der Takt, eine negative Flanke hat, hat das emittierte Lichtsignal denselben logischen Wert wie das Datensignal, nämlich den logischen Wert 1 bei t₁, den logischen Wert 1 bei t₂ und den logischen Wert 0 bei t₃. Betrachtet man die Zeitpunkte t₁, t₂ und t₃ als die durch den Takt festgelegten Abtastzeitpunkte für das Datensignal, so kann man den nach dem vorstehend geschilderten Verfahren betriebenen Halbleiterlaser als Abtast- und Halteglied für ein als optisches Signal vorliegendes Datensignal betrachten. Die Haltezeit ist dabei mindestens so lange wie die Breite der Taktimpulse, da frühestens mit der positiven Taktflanke des Stroms I die Emissionswellenlänge von λ₁ wieder auf λ₂ springen kann.

Selbstverständlich ist es auch möglich, das Datensignal als Steuerstrom für den Bereich 10 zu verwenden und einen Takt in Form eines entsprechend intensitätsmodulierten Lichtsignals zu verwenden, das in den Bereich 11 eingestrahlt wird. In diesem Falle würde ein elektrisches Datensignal durch eine optische Taktimpulsfolge abgetastet. In beiden Fällen erscheint am Ausgang ein optisches Signal, dessen Wellenlänge zu den durch den Takt markierten Abtastzeitpunkten einen dem Datensignal entsprechenden logischen Wert hat.

## Patentansprüche

1. Verfahren zum Betreiben eines Halbleiterlasers, der auf einem Substrat (2) monolithisch integriert ist und eine Kavität besitzt, die sich oberhalb einer zur Grundfläche des Substrats (2) koplanaren Ebene erstreckt, verzweigt ist und mehrere separat steuerbare Bereiche (8, 9, 10, 11) hat,
bei dem in einem der Bereiche die Ladungsträgerdichte derart geändert wird, daß der Halbleiterlaser hinsichtlich der Wellenlänge (λ₁, λ₂) des von ihm ausgesendeten Lichts bistabil ist.

2. Verfahren nach Anspruch 1, dadurch gekennzeichnet, daß einer der Ströme, die durch die Bereiche (8 - 11) fließen, verändert wird.

3. Verfahren nach Anspruch 1, dadurch gekennzeichnet, daß in einen der Bereiche (8, 9, 11) ein Lichtsignal eingestrahlt wird, das eine höhere Energie als das von dem Halbleiterlaser (1) emittierte Lichtsignal hat.

4. Verfahren nach Anspruch 1, dadurch gekennzeichnet, daß sowohl einer der Ströme verändert wird, als auch ein Lichtsignal in mindestens einen der Bereiche (8, 9, 11) eingestrahlt wird, das eine höhere Energie hat als das von dem Halbleiterlaser (1) emittierte Lichtsignal.

5. Verfahren nach Anspruch 2, dadurch gekennzeichnet, daß der Strom eines Bereichs (10), der verändert wird, durch ein Signal moduliert wird, das mit einer Stromstärke (I₀ oder I₃) beginnt, bei der der Halbleiterlaser eindeutig Licht mit der ersten Wellenlänge (λ₁) oder eindeutig Licht mit der zweiten Wellenlänge (λ₂) emittiert, und daß das Signal nach seinem die erste oder die zweite Stromstärke aufweisenden Teil durch Ströme repräsentiert wird, bei denen der Halbleiterlaser eine Wellenlängen-Bistabilität hat.

6. Verfahren nach Anspruch 4, dadurch gekennzeichnet, daß der Strom eines Bereichs, der verändert wird, durch eine Taktimpulsfolge (I, Fig. 3) moduliert wird und daß das in einen der Bereiche eingestrahlte Lichtsignal ein Datensignal (D, Fig. 3) darstellt, oder umgekehrt.

7. Verfahren nach Anspruch 1, dadurch gekennzeichnet, daß in einem der Bereiche die Ladungsträgerdichte derart geändert wird, daß entsprechend der Änderung außer der Wellenlänge des emittierten Lichts die Intensität sich ändert, indem der Halbleiterlaser Licht mit einer niedrigen oder hohen Intensität emittiert.

## Claims

1. Method of operating a semiconductor laser that is monolithically integrated on a substrate (2) and has a cavity layer extending above a plane that is coplanar with the base surface of the substrate (2), is branched and includes a plurality of separately controllable regions (8, 9, 10, 11), in which the charge carrier density is changed in one of the regions in such a way that the semiconductor laser is bistable with respect to the wavelength (λ₁, λ₂) of the light it has emitted.

2. Method according to claim 1, characterized in that one of the currents flowing through the regions (8 - 11) is changed.

3. Method according to claim 1, characterized in that a light signal of a higher energy than the light signal emitted by the semiconductor laser (1) is introduced into one of the regions (8, 9, 11).

4. Method according to claim 1, characterized in that one of the currents is changed and a light signal having a higher energy than the light signal emitted by the semiconductor laser (1) is introduced into at least one of the regions (8, 9, 11).

5. Method according to claim 2, characterized in that the current that is changed in one region (10) is modulated by a signal that begins with a current intensity (I₀ or I₃) at which the semiconductor laser unequivocally emits light at the first wavelength (λ₁) or unequivocally emits light at the second wavelength (λ₂) and, according to its component having the first or the second current intensity, the signal is represented by currents at which the semiconductor laser exhibits wavelength bistability.

6. Method according to claim 4, characterized in that the current that is changed in one region is modulated by a succession of clock pulses (I, Fig. 3) and the light signal introduced into one of the regions represents a data signal (D, Fig. 3) or vice versa.

7. Method according to claim 1, characterized in that the charge carrier density is changed in one of the regions in such a way that, corresponding to the change, in addition to the wavelength of the emitted light, its intensity also changes in that the semiconductor laser emits light at a low intensity or at a high intensity.

## Revendications

1. Procédé pour exploiter un laser à semiconducteur qui est intégré en mode monolithique sur un substrat (2) et qui présente une cavité qui s'étend au-dessus d'un plan coplanaire à la surface de base du substrat (2), bifurque et comporte plusieurs zones (8, ç, 10, 11) pouvant se commander séparément, dans le cas duquel, dans l'une des zones, on modifie la densité des porteurs de charges de façon que le laser à semiconducteur soit bistable à l'égard de la longueur d'onde (λ₁, λ₂) de la lumière émise par lui.

2. Procédé selon la revendication 1, caractérisé par le fait que l'on modifie l'un des courants qui passent par les zones (8-11).

3. Procédé selon la revendication 1, caractérisé par le fait que sur l'une des zones (8, 9, 11), on fait tomber un signal lumineux qui présente une énergie supérieure à celle du signal lumineux émis par le laser à semiconducteur (1).

4. Procédé selon la revendication 1, caractérisé par le fait que l'on peut aussi bien modifier l'un des courants que faire tomber, sur au moins l'une des zones (8, 9, 11), un signal lumineux qui possède une énergie supérieure à celle du signal lumineux émis par le laser à semiconducteur (1).

5. Procédé selon la revendication 2, caractérisé par le fait que l'on module le courant d'une zone (10) que l'on modifie au moyen d'un signal qui commence avec une intensité (I₀ ou I₃) dans le cas de laquelle le laser à semiconducteur émet de façon non ambiguë de la lumière avec la première longueur d'onde (λ₁) ou, de façon non ambiguë, de la lumière avec la seconde longueur d'onde (λ₂), et que, selon sa partie présentant la première ou la seconde intensité, le signal est représenté par des courants dans le cas desquels le laser à semiconducteur présente une bistabilité en ce qui concerne la longueur d'onde.

6. Procédé selon la revendication 4, caractérisé par le fait que l'on module le courant passant dans une zone, que l'on modifie, au moyen d'une suite d'impulsions d'horloge (I, figure 3), et que le signal lumineux qui tombe sur l'une des zones représente un signal de données (D, figure 3) ou inversement.

7. Procédé selon la revendication 1, caractérisé par le fait que dans l'une des zones on modifie la densité des porteurs de charges de façon qu'en fonction de la modification, en plus de la longueur d'onde de la lumière émise, l'intensité se modifie en ce sens que le laser à semiconducteur émet de la lumière d'une intensité basse ou haute.
